Europäisches Patentamt

European Patent Office

Office européen des brevets

(19)

(11) Numéro de publication: **0 335 798**
**A1**

(12)

# DEMANDE DE BREVET EUROPEEN

(21) Numéro de dépôt: **89400877.0**

(22) Date de dépôt: **29.03.89**

(51) Int. Cl.4: **C 04 B 35/00**
**H 01 L 39/24, H 01 L 39/12**

(30) Priorité: **01.04.88 FR 8804366**

(43) Date de publication de la demande:
**04.10.89 Bulletin 89/40**

(84) Etats contractants désignés:
**AT BE CH DE ES FR GB GR IT LI LU NL SE**

(71) Demandeur: **RHONE POULENC CHIMIE**
**25 Quai Paul Doumer**
**F-92408 Courbevoie Cédex (FR)**

(72) Inventeur: **Chevallier, Bernard**
**Résidence Lahire rue Henri de Montherland**
**F-33400 Talence (FR)**

**Dance, Jean-Michel**
**Résidence Compostelle**
**F-33600 Pessac (FR)**

**Etourneau, Jean**
**5, Choisy Latour**
**F-33610 Cestas (FR)**

**Lozano, Lucien**
**32, avenue Gaston Cabannes**
**F-33560 Carbon Blanc (FR)**

**Tressaud, Alain**
**28, rue des Poilus**
**F-33600 Pessac (FR)**

**Tournier, Robert**
**l'Archat**
**F-38850 Bilieu (FR)**

**Sulpice, André**
**22, rue Edouard Vaillant**
**F-38000 Grenoble (FR)**

**Chaussy, Jacques**
**20, allée François Villon**
**F-38130 Echirolles (FR)**

**Lejay, Pascal**
**71bis Cours Saint André**
**F-38800 Pont de Claix (FR)**

(74) Mandataire: **Dubruc, Philippe et al**
**RHONE-POULENC CHIMIE Service Brevets Chimie 25,**
**quai Paul-Doumer**
**F-92408 Courbevoie Cédex (FR)**

(54) **Matériaux supraconducteurs stabilisés et leur procédé d'obtention.**

(57) L'invention a trait à un procédé de traitement de matériaux céramiques supraconducteurs, caractérisé par le fait que l'on soumet lesdit matériaux à une fluoruration à une température inférieure ou égale à 120°C.

Elle concerne également de nouveaux matériaux supraconducteurs caractérisés par le fait qu'ils comprennent des atomes de fluor distribués selon un gradient de concentration décroissant de la surface au coeur desdits matériaux.

Les matériaux selon l'invention possèdent des propriétés supraconductrices stabilisées et/ou améliorées.

EP 0 335 798 A1

Description

# MATERIAUX SUPRACONDUCTEURS STABILISES ET LEUR PROCEDE D'OBTENTION

La présente invention a trait au domaine des matériaux supraconducteurs hautes températures, ci-après dénommés supraconducteurs HT.

Plus précisement, l'invention vise à fournir, notamment au moyen d'un procédé de traitement de fluoruration basse température, de nouveaux supraconducteurs HT présentant des propriétés supraconductrices stabilisées ou même améliorées.

On sait que la supraconductivité se caractérise entre autre par la disparition de toute résistance électrique dans un corps porté à très basse température et par l'apparition de propriétés diamagnétiques lorsque ledit corps est en outre placé dans un champ magnétique extérieur.

Jusqu'à un passé récent, l'état supraconducteur dans certains matériaux n'apparaissait qu'en-dessous d'une température seuil, dite "température critique", généralement proche du zéro absolu. Une telle contrainte a constitué à l'évidence un frein sérieux au développement sur une grand échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures.

Plus spécifiquement, la découverte récente de matériaux oxygénés à base de cuivre, de terre-rare (lanthane, yttrium, erbium...) ou de bismuth ou de thallium, et d'alcalino-terreux (baryum, strontium, calcium ...) possédant des températures critiques élevées (Tc) a ouvert une voie de recherche inespérée dans le domaine de la supraconductivité HT.

Durant l'année 1987, une véritable avalanche de résultats sur la synthèse et sur les caractérisations chimiques et physiques de très nombreux nouveaux matériaux supraconducteurs a eu lieu.

Parmi les systèmes les plus étudiés, on peut citer plus particulièrement Y-Ba-Cu-O dans lequel les phases dérivant de $YBa_2Cu_3O_7$ possèdent des températures critiques voisines de 92 K.

Certaines publications ont même fait état de l'obtention de supraconducteurs à des températures proches de, voire supérieures à, la température ambiante. Dans ces derniers cas toutefois, les expériences n'ont pu être reproduites de manière satisfaisante.

Ces matériaux ouvrent des perspectives dans des domaines extrêmement variés que ce soit dans la microélectronique rapide grâce à l'annulation de la résistivité des connexions, dans la fabrication de bobines supraconductrices de stockage, dans les applications de supraconducteurs à haut champ critique pour transport par sustentation et en règle générale dans toutes les techniques qui utilisent actuellement des aimants supraconducteurs.

Mais l'amélioration des performances des matériaux supraconducteurs HT et en particulier l'augmentation de leur température critique, passe tout d'abord par la stabilisation des phases possédant une quantité de lacunes anioniques parfaitement définie ou, en d'autres termes, par une parfaite stabilité vis-à-vis de l'atmosphère ambiante. Il est bien connu d'autre part que les défauts intervenant en surface perturbent les propriétés intrinsèques des matériaux.

L'un des buts que s'est fixée la présente invention consiste donc dans l'élimination de ces défauts et le stabilisation des propriétés de coeur, et ceci par formation en surface d'une couche passivante, bloquant ainsi tout échange ultérieur entre le matériau supraconducteur et l'atmosphère.

On a maintenant trouvé, et il s'agit là d'un des premiers objets de la présente invention, qu'il est possible d'obtenir des matériaux supraconducteurs hautes températures à propriétés stabilisées au moyen du nouveau procédé de traitement selon l'invention, ledit procédé étant caractérisé en ce qu'il consiste à soumettre lesdits matériaux à un traitement de fluoruration à une température inférieure ou égale à 120°C.

Il est essentiel, selon l'invention, que le traitement de fluoruration tel que développé ci-après se trouve globalement limité à la surface des matériaux considérés, sans qu'en soient substantiellement modifiées leurs propriétés de coeur. L'instabilité des propriétés des matériaux supraconducteurs HT, dûe elle-même notamment à l'instabilité de l'oxygène, est alors efficacement neutralisée par la création d'une véritable barrière de diffusion (indifféremment appelée par la suite couche passivante ou bien couche isolante) à la surface desdits matériaux, évitant ainsi tout échange avec l'environnement extérieur, notamment avec l'oxygène, la vapeur d'eau ou le dioxyde de carbone contenus dans l'air ambiant et généralement reconnus comme responsables, entre autres causes, de la dégradation des propriétés supraconductrices.

Mais d'autres caractéristiques et avantages de l'invention apparaitront encore plus clairement à la lecture de la description qui va suivre, et des exemples concrets, mais non limitatifs, destinés à l'illustrer dans ses divers aspects.

On notera d'ores et déjà que l'exposé qui suit n'est pas limité au traitement et à l'obtention d'une composition supraconductrice particulière ; il doit être au contraire considéré comme étant de portée générale, c'est à dire comme pouvant s'appliquer au traitement et à la préparation de toute composition supraconductrice HT, dès lors que la stabilisation, voire l'amélioration, des propriétés supraconductrices de cette dernière est recherchée.

A titre d'exemple de compositions supraconductrices HT susceptibles d'être traitées selon la présente invention, on peut plus particulièrement citer celles à base de terres rares (on entend par terre rare d'une part tout élément du Tableau Périodique dont le numéro atomique est compris, inclusivement entre 57 et 71, et d'autre part l'yttrium qui, par convention, est assimilé ici à une terre rare), d'alcalino-terreux, de métaux de transition et d'oxygène (céramiques supraconductrices de type oxyde).

Les terres rares plus particulièrement préférées sont choisies parmi l'yttrium, le lanthane et l'erbium.

Les alcalino-terreux sont avantageusement choisis parmi le baryum, le strontium et le calcium.

Enfin, concernant les métaux de transition, on utilise de préférence le cuivre, bien que tout autre métal de transition puisse éventuellement convenir.

Le procédé selon l'invention s'applique particulièrement bien au traitement des systèmes supraconducteurs du type Y-Ba-Cu-O ; ces systèmes ont été étudiés notamment dans un article paru dans le Journal of American Chemical Society, 1987, 109, 2528-2530 ; plus spécifiquement encore, la formulation $YBa_2Cu_3O_{7-x}$ ($0 \leqq x \leqq 0,5$) constitue un exemple particulièrement remarquable de matériaux supraconducteurs HT susceptibles d'être utilement soumis au procédé de traitement selon l'invention.

Plus généralement, et de manière non limitative, les matériaux supraconducteurs destinés à subir le traitement selon l'invention peuvent se trouver à l'état de poudres ou bien encore à l'état de produits denses frittés.

Ces matériaux peuvent avoir été obtenus par tout moyen bien connu en soi.

Ainsi, lorsqu'il s'agit de poudres, ils peuvent avoir été notamment obtenus par chamottage, c'est à dire selon une méthode consistant essentiellement à faire réagir en phase solide et à haute température un mélange de poudres d'oxydes et/ou de sels contenant un anion volatil (par exemple le carbonate) des divers éléments destinés à constituer la composition supraconductrice désirée.

Ces poudres peuvent également avoir été préparées par pyrolyse de compositions précurseurs préalablement obtenues au moyen de diverses réactions se déroulant en phase liquide (par exemple par coprécipitation d'espèces minérales et/ou organiques dans une phase aqueuse).

Lorsqu'il s'agit de pièces denses, ces dernières peuvent alors avoir été obtenues par la mise en oeuvre de procédés classiques de frittage opérés sur les poudres précédentes.

Selon l'invention, on soumet alors ces matériaux à un traitement de fluoruration.

L'agent de fluoruration est de préférence gazeux, mais l'utilisation d'un agent se présentant sous la forme d'un solide ou d'un liquide n'est bien entendu pas exclue.

A titre d'exemples d'agents fluorurants convenant pour la mise en oeuvre du traitement selon l'invention, on peut plus particulièrement citer le fluor $F_2$, l'acide fluorhydrique HF, le tétrafluorométhane, les fluorures d'halogènes, les fluorures de gaz rares, le fluorure d'azote $NF_3$ et le fluorure de bore $BF_3$.

De préférence, on opèrera avec du fluor.

L'agent fluorurant peut être utilisé pur ou en dilution dans un gaz neutre, par exemple dans de l'azote.

La pression (ou la pression partielle) du gaz fluorurant n'est pas critique ; elle peut être comprise entre quelques millibars et plusieurs bars, mais pour des raisons pratiques on opère généralement sous des pressions de l'ordre du bar.

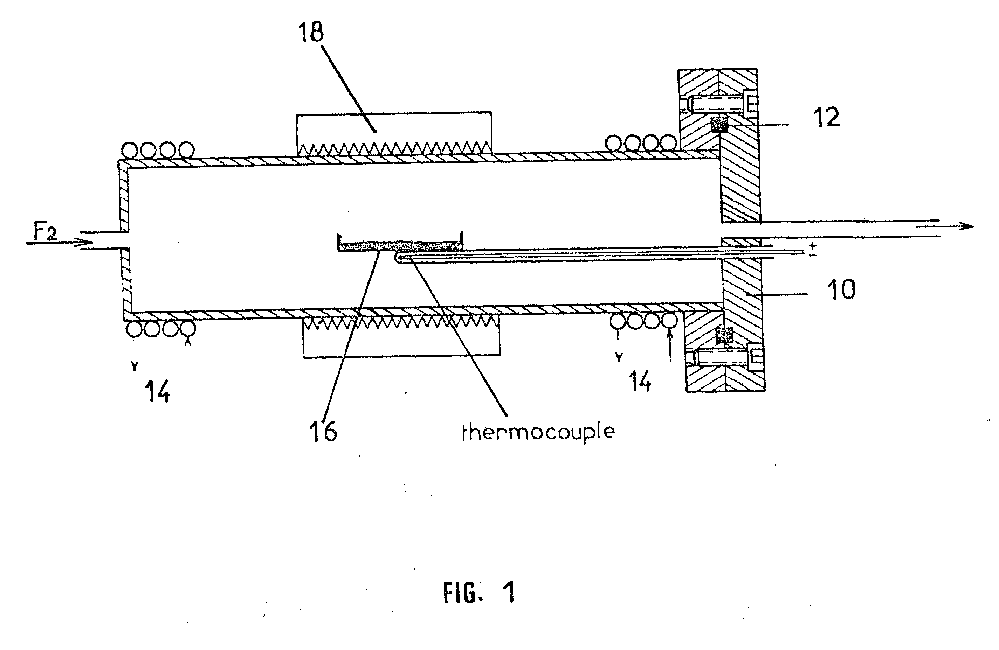

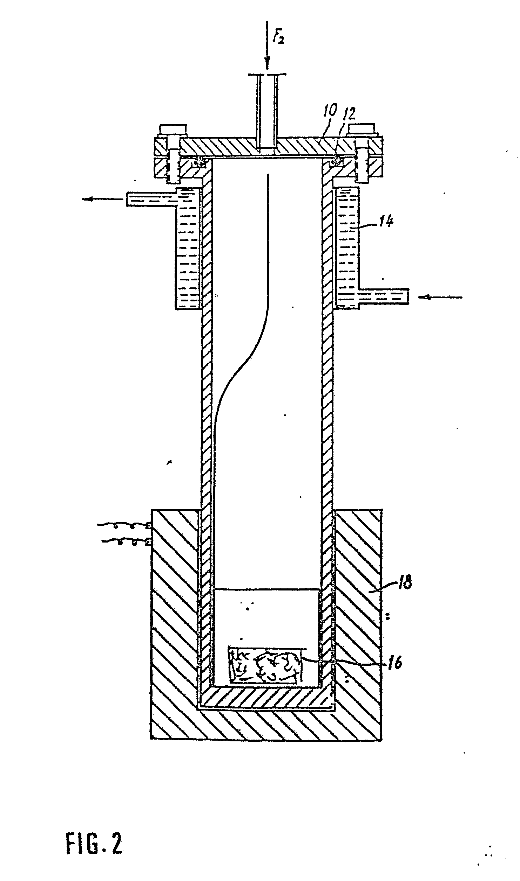

On a représenté aux figures 1 et 2 deux types de dispositifs susceptibles d'être utilisés pour la mise en oeuvre du traitement selon l'invention.

Ceux-ci sont composés d'un corps en nickel muni à l'une des extrêmités d'une flasque amovible (10) en nickel également. L'étanchéité est assurée à l'aide d'un joint torique en polymère fluoré ("teflon" par exemple) (12). Ce dispositif permet d'utiliser le gaz fluorurant soit sous atmosphère statique soit sous balayage.

L'alimentation en gaz s'effectue à l'aide d'un équipement classique en respectant les précautions d'usage (consulter "Inorganic Solid Fluorides", Academic Press 1985).

Les pressions admises varient entre quelques mbar et 10 bar. Le gaz fluorurant, comme déjà indiqué, peut être utilisé pur ou dilué dans un gaz neutre. Des circuits de refroidissement extérieurs (14) permettant la condensation et la récupération d'éventuels fluorures et oxyfluorures volatils. La partie centrale du réacteur dans laquelle sont placés les échantillons de supraconducteurs HT à traiter (16) est munie d'un four à résistance classique (18) pourvu d'un système de régulation qui permet d'obtenir des températures de réaction comprises entre la température ambiante et 600°C.

Selon une caractéristique essentielle du procédé selon l'invention le traitement de fluoruration est mené à une température n'excédant pas 120°C. Encore plus préférentiellement, ce traitement est mené à température ambiante, c'est à dire aux environs de 20°C.

La durée du traitement peut être comprise entre une et plusieures heures, de préférence de l'ordre d'une dizaine d'heures.

Cette limitation en température est extrêmement importante pour ne pas modifier la structure à coeur du matériau. Comme en effet déjà indiqué précédemment, le traitement selon l'invention ne doit avoir substantiellement d'autre effet que celui de modifier les caractéristiques de surface du matériau supraconducteur, et ceci par création d'une fine couche passivante destinée en quelque sorte à encapsuler ledit matériau.

Les matériaux supraconducteurs ainsi traités constituent l'un des seconds objets de la présente invention.

Ces matériaux sont caractérisés par le fait qu'ils comprennent des atomes de fluor distribués selon un gradient de concentration décroissant de la surface au coeur desdits matériaux.

Les matériaux selon l'invenion présentent en outre au moins l'une des caractéristiques suivantes :
- les atomes de fluor sont majoritairement répartis dans la couche externe desdits matériaux. On entend ici par couche externe une épaisseur de matière, mesurée à partir de la surface du matériau, de l'ordre de quelques centaines d'Angströms.
On entend d'autre part par majoritairement que plus de 50 % des atomes de fluor présents dans le matériau se trouvent dans ladite couche externe
- ladite couche externe est de type amorphe
- le pourcentage en poids des atomes de fluor présents dans le matériau n'excède pas 2 %, et de préférence 1 %

- les atomes de fluor sont présents dans le matériau sous la forme de composés fluorés ou oxyfluorés.

Les matériaux supraconducteurs tels que caractérisés ci-dessus présentent alors les propriétés intéressantes suivantes :

d'une part, ils résistent parfaitement à l'air ambiant, c'est à dire que leur propriétés supraconductrices ne se dégradent pas au cours du temps ; d'autre part, soumis à un post-traitement thermique approprié, ces matériaux voient leurs propriétés magnétiques (effet MEISSNER) améliorées ; enfin, ils présentent une température critique Tc supérieure à celle des matériaux supraconducteurs correspondants non traités.

L'amélioration des propriétés précitées sera clairement mise en évidence dans les exemples concrets donnés ci-après.

D'autre part, il demeure bien entendu que la présenté invention n'est pas limitée à ces divers exemples de mise en oeuvre, mais qu'elle englobe toutes les variantes possibles.

C'est ainsi que des modifications de certains paramètres expérimentaux tels que pression, dilution et nature de gaz fluorurant ; durée et régime (dynamique ou statique) de la fluoruration ; etc ... permettant une optimisation de la passivation des supraconducteurs HT peuvent être apportées dans la mise en oeuvre du procédé conforme à l'invention sans se départir du cadre et de l'esprit de cette invention.

En outre, comme déjà indiqué, ce procédé peut être étendu à la passivation de l'ensemble des matériaux supraconducteurs HT, quelles que soient leurs mises en forme : poudres, pièces denses frittées, couches minces, fils, cristaux et réseaux de couches.

Dans ce dernier cas, on entend notamment la réalisation de jonctions "Josephson", la couche fluorée étant l'isolant de la jonction. On entend également la réalisation de produits constitués d'un substrat supportant une couche supraconductrice comportant elle-même à sa surface une couche isolante, ou bien encore de produits constitués alternativement d'une succession de couches supraconductrices et de couches isolantes, tous ces produits trouvant une application privilégiée dans le domaine de l'électronique et de la microéléctronique.

Les divers aspects de l'invention vont maintenant être illustrés dans le cadre particulier de matériaux supraconducteurs du type Y-Ba-Cu-O, se présentant sous forme de poudres ou de pièces frittés.

## 1- Préparation des échantillons témoins

### 1.1 Poudres

Une poudre supraconductrice de formule générale $YBa_2Cu_3O_{7-x}$ ($0 \leq x \leq 0,5$) est préparée par chamottage d'un mélange contenant, dans les rapports stoechiométriques et sous forme de poudres, de l'oxyde d'yttrium $Y_2O_3$, du carbonate de baryum $BaCO_3$ et de l'oxyde de cuivre $CuO$, et ceci dans les conditions suivantes :
- 2 cycles de 20 heures à 900° C et sous air, suivis de broyages,

- puis un cycle de 24 heures à 500° C et sous air, suivi d'un refroidissement de 100° C/heures jusqu'à température ambiante.

### 1.2 Pièces frittées

Des pièces denses supraconductrices de formule $YBa_2Cu_3O_{7-x}$ ($0 \leq x \leq 0,5$) sont préparées par frittage des poudres précédentes dans les conditions suivantes :
- pastillage des poudres sous 2 tonnes/$cm^2$
- un cycle de 20 heures à 900° C sous air, suivi d'un broyage puis à nouveau d'un pastillage,
- un cycle de 20 heures à 900° C sous air
- un cycle de 24 heures à 500° C sous air, suivi d'un refroidissement de 100° C/heures jusqu'à température ambiante.

## 2- Exemples

### Exemple 1

Cet exemple a pour but d'illustrer l'influence de la température dans le traitement selon l'invention.

Une poudre témoin telle que préparée précédemment est fluorée dans l'équipement décrit à la figure 1 pendant un cycle de 8 heures sous léger courant de 1 bar de fluor non dilué, suivi d'un cycle de 12 heures sous une atmosphère statique de 1 bar de fluor pur.

Le traitement a été réalisé à diverses températures dans le but de mettre clairement en évidence le caractère critique de ce paramètre dans le procédé selon l'invention.

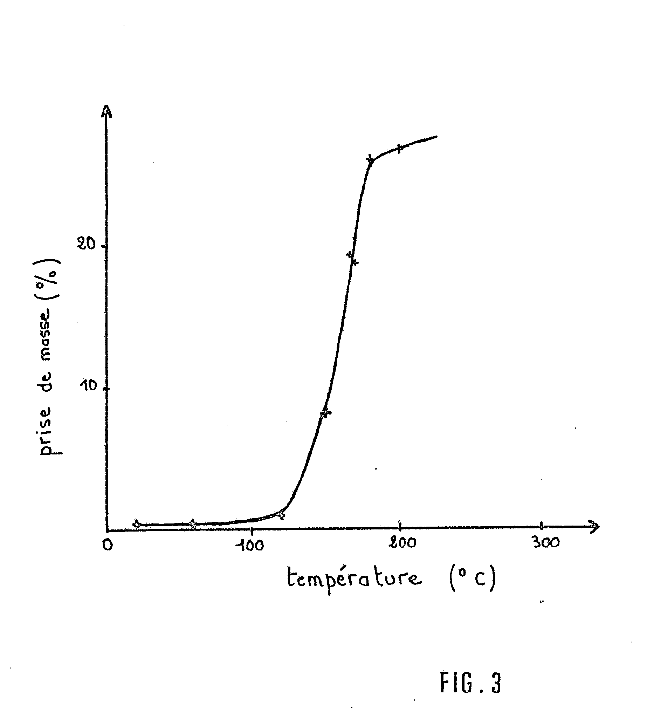

On a représenté à la figure 3 l'évolution de la prise de masse de l'échantillon en fonction de la température de traitement.

Cette courbe montre clairement que l'on doit se limiter à des températures n'éxcédent pas 120° C pour éviter une prise de masse trop importante, c'est à dire excédant 1%, et qui correspondrait alors à une modification sensible des propriétés volumiques de la poudre.

On se limitera donc dans les exemples suivants à des traitements thermiques n'excédant pas 120° C.

### Exemple 2

Cet exemple a pour but de mettre en évidence les caractéristiques de surface d'une poudre traitée selon l'invention.

Une poudre supraconductrice témoin est traitée à 20° C selon les modalités pratiques définies à l'exemple 1.

La prise en masse de la poudre est de 0,4 %. Le spectre de diffraction X est identique à celui d'une poudre témoin non traitée.

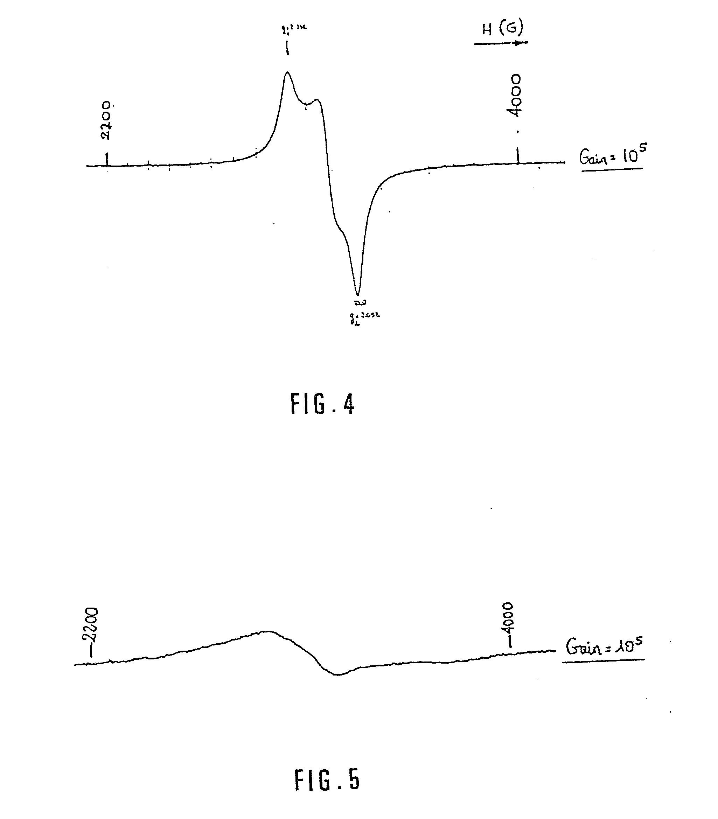

Les différences apparaissant entre les spectres RPE (résonnance paramagnétique électronique) d'une poudre témoin et d'une poudre fluorée, représentés respectivement aux figures 4 et 5, montrent que le signal de l'échantillon témoin, qui est dû à la résonance d'électrons localisés d'ions $Cu^{2+}$ (effet de surface par exemple) disparait complètement après fluoruration.

## Exemple 3

Comme l'exemple 2, cet exemple a également pour but de mettre en évidence certaines caractéristiques de surface des produits traités selon l'invention.

Un échantillon témoin fritté tel que préparé au point 1.2 est traité à 20° C sous fluor selon les modalités pratiques de l'exemple 1.

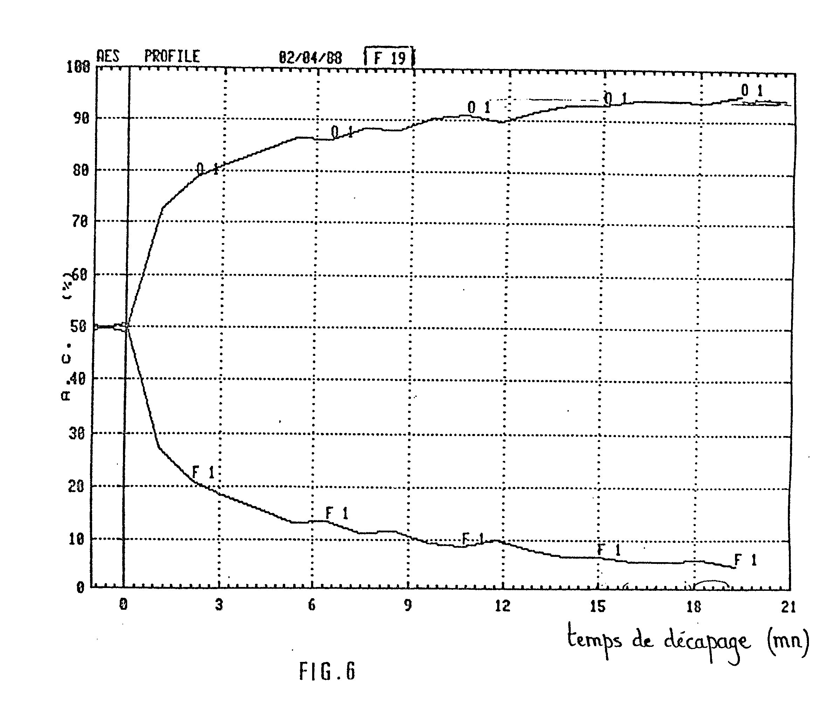

On a représenté à la figure 6 un spectre AUGER (AES Auger Electron Spectroscopie) du produit traité, indiquant le profil de la teneur en fluor et en oxygène dans les couches extérieures de l'échantillon. En ordonnées sont représentées les concentrations atomiques relatives en % du fluor et de l'oxygène ($F/_{F+O}$ ou $O/F+O$), et en abscisse le temps de bombardement de la surface a analyser (temps de décapage).

La vitesse de décapage est de 50 Å/mn pour les temps compris entre 1 et 15 mn ; elle est de 200 Å/mn après 15 mn.

Ce spectre montre clairement que les atomes de fluor sont préférentiellement distribués sur une couche externe de matière dont l'épaisseur est de l'ordre de quelques centaines d'angströms.

## Exemple 4

Cet exemple a pour but de mettre en évidence, sur des poudres, le caractère passivant (ou stabilisant) du traitement selon l'invention.

Deux poudres supraconductrices, dont une poudre témoin telle que préparée au point 1.1 et une poudre selon l'invention telle que préparée selon l'exemple 2, sont laissées 4 mois à l'air libre (température ambiante).

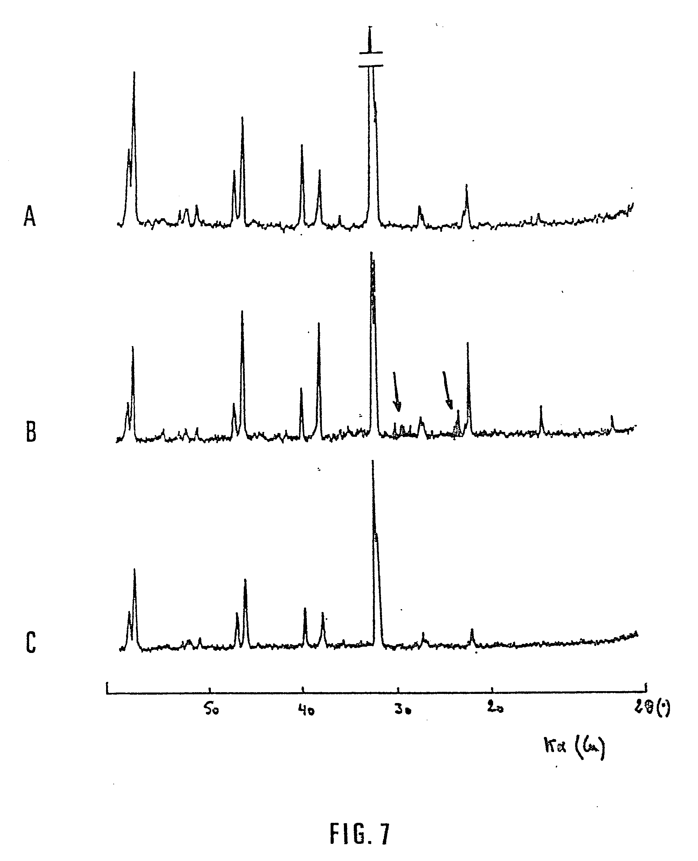

On a représenté à la figure 7 les spectres de diffraction X des poudres :
- témoin à l'instant initial (fig. 7.a)
- témoin après 4 mois (fig. 7.b)
- traitée selon l'invention après 4 mois (fig. 7.c)

Le spectre de la figure 7.b permet d'identifier clairement l'apparition de carbonate de baryum à la surface du produit. Le baryum de la phase Y-Ba-Cu-O, en raison de sa grande affinité avec le $CO_2$, a donc réagi avec l'air ambiant pour donner $BaCO_3$, et ceci au détriment de la phase supraconductrice. Le spectre de la figure 7.c montre que la formation de $BaCO_3$ sur l'échantillon traité a été inhibée.

## Exemple 5

Cet exemple a pour but de mettre en évidence, sur des frittés, le caractère passivant du procédé selon l'invention.

Deux pièces frittées supraconductrices, dont une pièce témoin telle que préparée au point 1.2 et une pièce selon l'invention préparée selon l'exemple 3, sont laissées 4 mois à l'air libre (température ambiante).

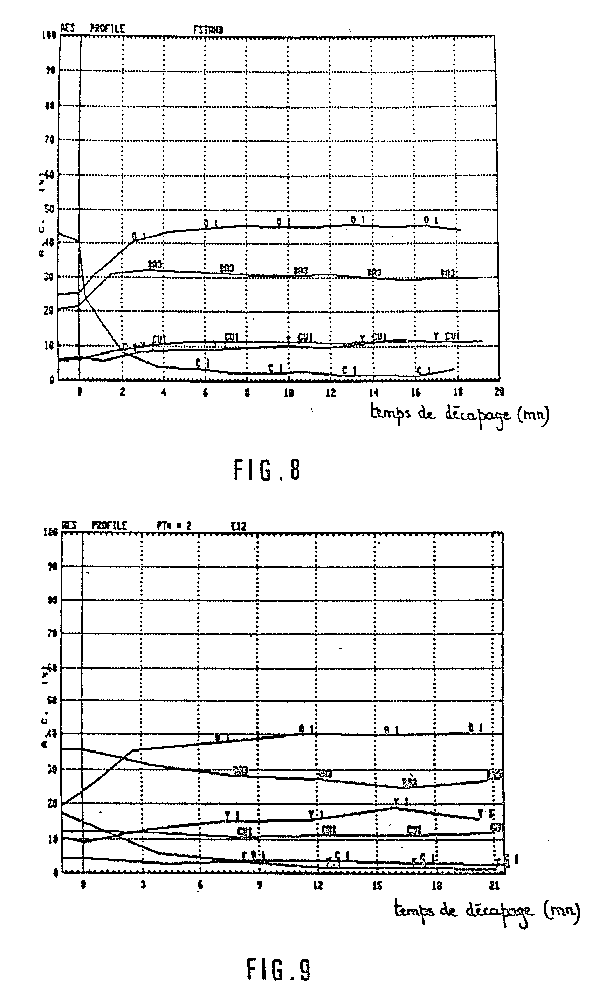

On a représenté aux figures 8 et 9, les spectres AUGER d'une part de la pièce témoin non traitée après 4 mois (fig. 8) et d'autre part de la pièce traitée, après 4 mois (fig. 9).

Les profils atomiques des deux échantillons montrent que dans le cas du produit traité selon l'invention, la formation de carbone superficiel provenant de $BaCO_3$ a été inhibée par la présence du fluorure superficielle.

## Remarques

Dans le cas de la figure 8, la vitesse de décapage est de 50 Å/mn pour les temps compris entre 0 et 14 mn ; elle est de 250 Å/mn après 14 mn.

Dans le cas de la figure 9, cette vitesse est de 40 Å/mn pour les temps compris entre 0 et 6 mn ; elle est de 210 Å/mn après 6 mn.

## Exemple 6

Cet exemple a pour but de mettre en évidence, par une autre méthode, l'effet de protection du traitement selon l'invention.

Cette méthode consiste à soumettre à un traitement thermique à 500°C, sous vide secondaire et pendant 2 heures, d'une part une poudre supraconductrice telle que préparée au point 1.1 (échantillon 1) et d'autre part une poudre telle que préparée selon l'exemple 2 (échantillon 2).

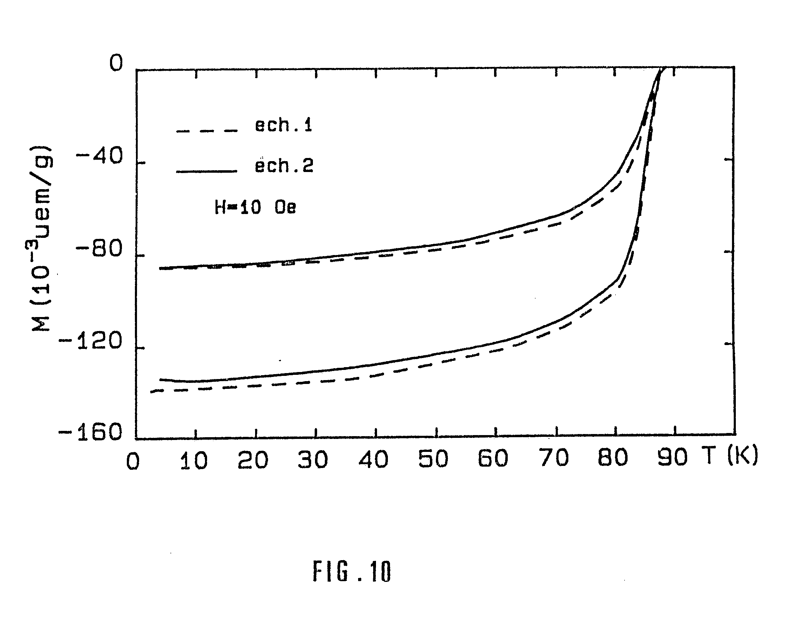

On a représenté à la figure 10 les courbes d'aimantation des échantillons 1 et 2 avant traitement thermique (l'aimantation M est exprimée classiquement en unité électromagnétique par gramme ; le champ extérieur appliqué est de 10 oerstedts) ; ces courbes montrent qu'au départ les deux échantillons ont sensiblement les mêmes propriétés diamagnétiques.

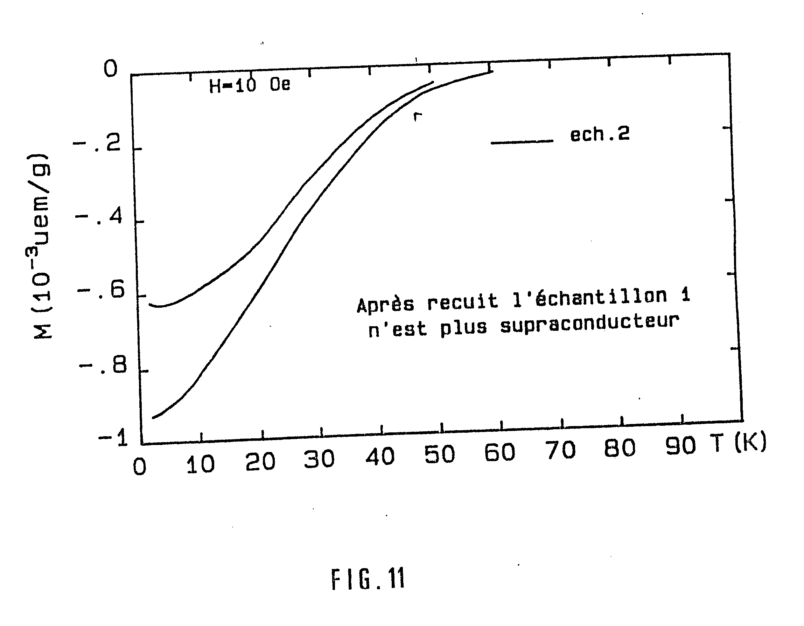

On a représenté à la figure 11 les courbes d'aimantation des échantillons après le traitement thermique précité.

On constate que les propriétés supraconductrices de l'échantillon 1 ont été détruites par départ de l'oxygène (absence de diamagnétisme) ; par contre, on constate que sur l'échantillon 2 traité selon l'invention, les propriétés supraconductrices n'ont pas totalement disparues, et ceci grâce à l'existence d'une barrière de diffusion à la surface de l'échantillon.

## Exemple 7

Cet exemple a pour but de mettre en évidence l'influence d'un post-traitement thermique approprié pour l'amélioration des propriétés magnétiques des produits traités selon l'invention.

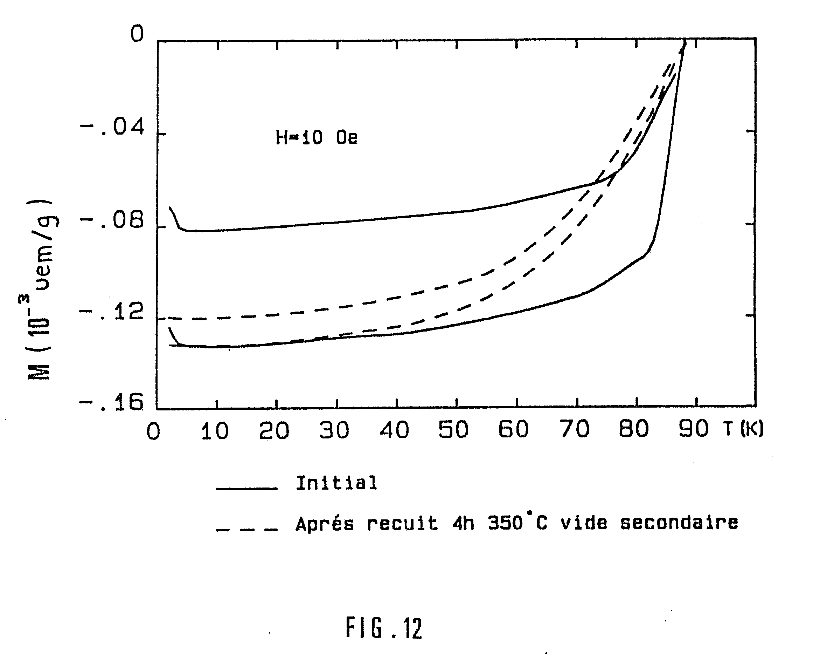

On a représenté à la figure 12, les courbes d'aimantation d'une part d'une poudre selon l'invention telle que préparée à l'exemple 1 en utilisant une température de 60°C (échantillon initial) et d'autre part de cette même poudre traitée ultérieurement sous vide secondaire à 350°C pendant 4 heures.

Ces courbes montrent clairement que le traitement de recuit défini ci-dessus permet de modifier les propriétés magnétiques de l'échantillon initial, et plus particulièrement la courbe d'expulsion du champ magnétique, aussi appelée effet MEISSNER. Plus précisemment encore, cette courbe montre une augmentation de l'effet MEISSNER sur l'échantillon post-traité.

Une telle propriété peut être intéressante pour une utilisation dans les appareils d'écrantage magnétique sous champs faibles.

Un tel recuit sur un échantillon non préalablement traité au fluor a au contraire pour effet de diminuer l'effet MEISSNER.

Exemple 8

Cet exemple a pour but de mettre en évidence l'amélioration des propriétés électroniques d'un fritté supraconducteur traité selon l'invention.

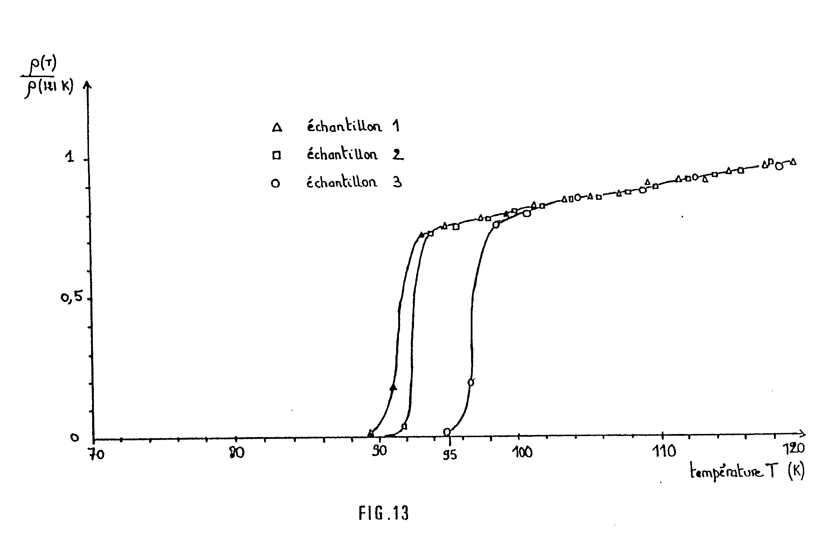

On a représenté à la figure 13 les courbes de résistivité, en fonction de la température, de trois échantillons frittés :
- un échantillon 1 tel que préparé au point 1.2
- un échantillon 2 résultant du traitement de l'échantillon 1 ci-dessus à 20° C sous fluor et selon les modalités pratiques de l'exemple 1
- un échantillon 3 résultant du traitement de l'échantillon 1 ci-dessus à 100°C sous fluor et toujours selon les modalités pratiques de l'exemple 1.

Ces courbes mettent clairement en évidence une amélioration de la température critique Tc des échantillons traités selon l'invention, cette amélioration étant de 5°K pour l'échantillon traité à 100°C.

Exemple 9

Cet exemple a pour but de mettre en évidence la formation d'une couche de composés fluorés à la surface d'un cristal traité selon l'invention, notamment d'une couche de fluorure organique.

L'étude de la surface de la couche passivante formée par fluoruration est effectuée par XPS (X-ray photoelecton spectroscopy). Cette méthode nécessite l'utilisation d'un cristal qui peut être préparé notamment selon la méthode proposée par D.L. KAISER, S.HOLTZBERG, B.A. SCOTT et T.R.McGUIRE (Applied Physic Letters, 51, page 1040, 1987).

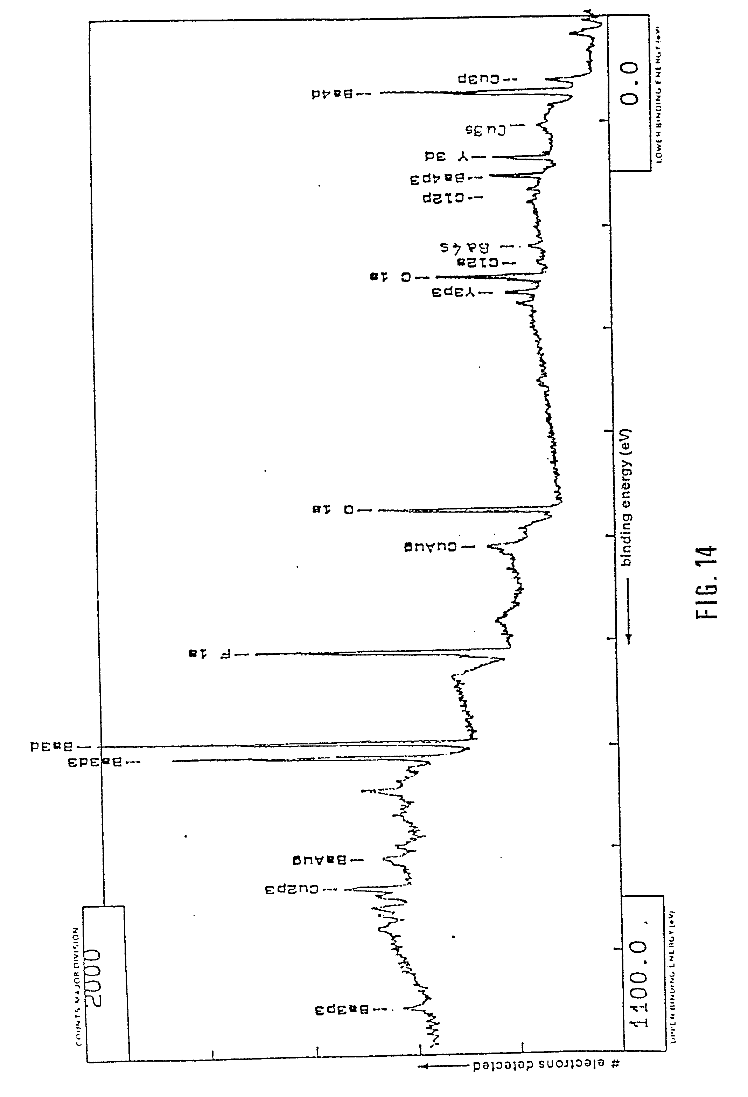

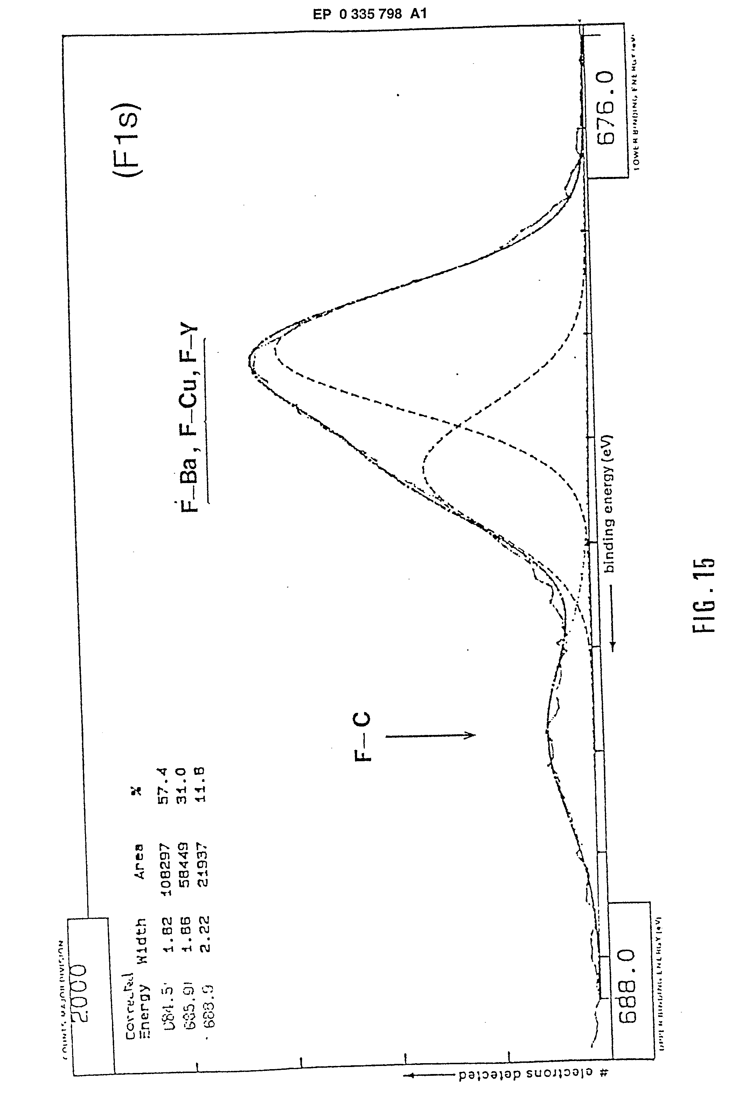

On a représenté à la figure 14 le spectre XPS complet d'un cristal de Y Ba$_2$ Cu$_3$ O$_{7-x}$ ($0 \leqq x \leqq 0,5$) traité sous fluor à 100°C selon les modalités pratiques définies à l'exemple 1, et à la figure 15 l'enveloppe du pic XPS (F1s) du fluor. Cette figure montre clairement la présence d'un pic à une énergie de transition Et $\approx$ 689 eV, caractéristique d'une liaison C-F identique à celle existant dans les fluorocarbones et dans les fluorures de graphite.

La teneur en fluorure organique peut être augmentée en ajoutant du graphite lors de l'expérience de fluoruration et/ou lorsque la surface du matériau avant traitement est fortement carbonatée. Cette couche peut être éliminée par chauffage de l'échantillon.

**Revendications**

1/ Matériau céramique à propriétés supraconductrices caractérisé par le fait qu'il comprend des atomes de fluor distribués selon un gradient de concentration décroissant de la surface au coeur dudit matériau.

2/ Matériau céramique selon la revendication 1 caractérisé par le fait que lesdits atomes de fluor sont majoritairement répartis dans la couche externe dudit matériau.

3/ Matériau céramique selon l'une quelconque des revendications précédentes caractérisé par le fait que le pourcentage en poids desdits atomes de fluor contenus dans ledit matériau n'excède pas 2 %.

4/ Matériau céramique selon la revendication 3 caractérisé par le fait que ledit pourcentage n'excède pas 1%.

5/ Matériau céramique selon l'une quelconque des revendications précédentes caractérisé par le fait que lesdits atomes de fluor sont présents dans ledit matériau sous la forme de composés fluorés ou oxyfluorés.

6/ Matériau céramique selon l'une quelconque des revendications précédentes caractérisé par le fait que ladite couche externe est de type amorphe.

7/ Matériau céramique selon l'une quelconque des revendications précédentes caractérisé par le fait qu'il est essentiellement à base d'au moins une terre rare, d'au moins un alcalino-terreux, d'au moins un métal de transition et d'oxygène.

8/ Matériau céramique selon la revendication 7 caractérisé par le fait que la terre rare est choisie parmi l'yttrium, le lanthane et l'erbium, l'alcalino-terreux choisi parmi le baryum, le strontium et le calcium, et le métal de transition est le cuivre.

9/ Matériau céramique selon la revendication 8 caractérisé par le fait qu'il répond essentiellement à la formule XBa$_2$Cu$_3$O$_{7-x}$ dans laquelle X représente l'yttrium, le lanthane ou l'erbium, et x représente un nombre compris inclusivement entre 0 et 0,5.

10/Procédé de traitement d'un matériau céramique à propriétés supraconductrices, caractérisé en ce qu'il consiste à soumettre ledit matériau à un traitement de fluoruration à une température inférieure ou égal à 120°C.

11/Procédé de traitement selon la revendication 10 caractérisé en ce que ladite température se situe aux environs de 20°C.

12/Procédé de traitement selon l'une quelconque des revendications 10 et 11, caractérisé en ce que ladite fluoruration est opérée au moyen d'un agent fluorurant gazeux.

13/Procédé de traitement selon la revendication 12 caractérisé en ce que ledit agent fluorurant est choisi parmi le fluor, l'acide fluorhydrique, le tétrafluorométhane, les fluorures d'halogènes, les fluorures de gaz rares, le fluorure d'azote et le fluorure de bore.

14/Procédé de traitement selon la revendication 13 caractérisé en ce que l'on utilise du fluor.

15/Procédé de traitement selon l'une quelconque des revendications 10 à 14 caractérisé en ce que ladite fluoruration se fait à pression atmosphérique.

16/Procédé de traitement selon l'une quelconque des revendications 10 à 15 caractérisé en ce qu'il est en outre suivi d'un post traitement thermique.

17/Procédé de traitement selon la revendication 16 caractérisé en ce que ledit post traitement thermique est opéré sous vide à une température inférieure ou égal à 500°C.

18/Utilisation d'un matériau céramique tel que défini à l'une quelconque des revendications 1 à 9 et/ou d'un procédé de traitement tel que défini à l'une quelconque des revendications 10 à 17, pour la préparation de composants ou de systèmes électroniques et/ou microélectroniques, notamment du type réseaux de couches.

FIG. 1

EP 0 335 798 A1

FIG. 2

FIG.3

EP 0 335 798 A1

FIG. 4

FIG. 5

AES    PROFILE        02/04/88    F 19

100
90    0 1    0 1    0 1
80    0 1
70
60
50
40
30
20    F 1
10    F 1    F·1    F 1    F 1    F 1
0

0    3    6    9    12    15    18    21

temps de décapage (mn)

a.c. (%)

FIG.6

FIG. 7

FIG.8

FIG.9

FIG.10

EP 0 335 798 A1

FIG. 11

EP 0 335 798 A1

H=10 Oe

—————— Initial

— — — Aprés recuit 4h 350°C vide secondaire

FIG.12

EP 0 335 798 A1

FIG.13

EP 0 335 798 A1

FIG. 14

EP 0 335 798 A1

FIG. 15

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | MATERIALS LETTERS, vol. 5, nos. 11-12, octobre 1987, pages 495-498, Elsevier Science Publisher B.V.(North-Holland Physics Publishing Division), Amsterdam, NL; A. BHARGAVA et al.: "Effects of atmosphere on Ba2YCu3Ox during processing" * En entier * | 1-18 | C 04 B  35/00 H 01 L  39/24 H 01 L  39/12 |
| A | PHYSICA, vol. 148B, 3 août 1987, pages 429-431, Elsevier Science Publishers B.V.(North-Holland Physics Publishing Division) and Yamada Science Foundation, Amsterdam, NL; O. KOHNO et al.: "Characteristics of high-Tc oxide wire" * En entier * | 1-18 | |

**DOMAINES TECHNIQUES RECHERCHES (Int. Cl.4)**

C 04 B
H 01 L

Le présent rapport a été établi pour toutes les revendications

| Lieu de la recherche | Date d'achèvement de la recherche | Examinateur |
|---|---|---|
| LA HAYE | 07-07-1989 | LUETHE H. |